# EUROPÄISCHE PATENTANMELDUNG

(11) **EP 0 902 230 A2**
(43) Veröffentlichungstag der Anmeldung: **17.03.1999**
(21) Anmeldenummer: 98116730.7
(22) Anmeldetag: 03.09.1998
(51) Int. Cl.: F16P 3/08

(54) **Schaltungsanordnung zur automatischen Einstellung eines sicheren Betriebszustands**

(30) Priorität: 11.09.1997 DE 19740031
(71) Anmelder: Dr. Johannes Heidenhain GmbH, D-83292 Traunreut (DE)
(72) Erfinder: Baumgartner, Alfons, Dipl.-Ing., 83224 Grassau (DE)

(57) **Zusammenfassung**

Es ist bekannt, daß bei Werkzeugmaschinen sicherheitsrelevante Betriebszustände durch Detektoren (D) ermittelt und an eine Steuereinheit (ST) weitergeleitet werden.

Es kann jedoch der Fall auftreten, daß aufgrund von mechanischer Beschädigung oder Alterung ein Kabelbruch in den Statusleitungen, über die die Detektoren (D) mit der Steuereinheit (ST) verbunden sind, auftritt. Dann kann ein Steuersignal für einen unsicherer Betriebszustand nicht mehr von einem Detektor (D) an die Steuereinheit (ST) weitergeleitet werden. Daher wird erfindungsgemäß ein sicherer Betriebszustand durch einen Signalpegel auf den Statusleitungen signalisiert, der durch entsprechende Maßnahmen permanent aufrecht erhalten werden muß. Tritt eine Unterbrechung einer Statusleitungen auf, kann der Signalpegel am Eingang der Steuereinheit nicht mehr aufrecht erhalten werden und durch den veränderten Signalpegel wird automatisch ein unsicherer Betriebszustand signalisiert.

## Beschreibung

Die Erfindung betrifft eine Schaltungsanordnung zur automatischen Einstellung eines sicheren Betriebszustands nach Anspruch 1.

Es ist bekannt, daß insbesondere Werkzeugmaschinen sicherheitsgerichtete Funktionen aufweisen. Dabei wird überwacht, ob durch einen Benutzer derart auf die Werkzeugmaschine eingewirkt wird, daß ein bezüglich der Betriebssicherheit problematischer Betriebszustand der Werkzeugmaschine entstehen kann. Eine derartige Benutzereinwirkung kann beispielsweise daraus bestehen, daß der Benutzer die Schutztür zum Arbeitsraum öffnet, während die Werkzeugmaschine ein NC-Programm mit hoher Geschwindigkeit abarbeitet. Dies wird von Detektoren an der Schutztür detektiert und die Steuerung der Werkzeugmaschine stellt einen sicheren Betriebszustand her, indem beispielsweise die Bearbeitungsgeschwindigkeit auf eine sicher begrenzte Geschwindigkeit verringert oder ein sicheren Halt durchgeführt wird.

Dadurch wird sichergestellt, daß sich der Benutzer auch beim Eindringen in den Arbeitsraum keine schweren Verletzungen zuziehen kann.

Dabei kann jedoch das Problem auftreten, daß die Leitungen, die die Detektoren, z.B. der Schutztür, mit der Steuereinheit verbinden aufgrund von Alterung, mechanischer Beschädigung oder versehentliches Ausstecken keine fehlerfreie Verbindung mehr zwischen Detektor und Steuereinheit herstellen und daher ein problematischer Betriebszustand nicht erkannt werden kann.

Es stellt sich somit die Aufgabe, eine Schaltungsanordnung anzugeben, bei der die Betriebssicherheit einer Werkzeugmaschine auch dann schnellstmöglich gewährleistet werden kann, wenn die Leitungen zwischen der Steuereinheit und den zur Detektion eines sicheren Betriebszustands benutzten Detektoren schadhaft werden.

Diese Aufgabe wird durch die in Anspruch 1 angegebenen Merkmale gelöst.

Das erfindungsgemäße Verfahren weist den Vorteil auf, daß die Signalpegel auf den Statusleitungen zu und von den entsprechenden Detektoren zur Signalisierung eines sicheren Betriebszustandes immer aktiv durch Anlegen eines bestimmten Signalpegels am Eingang des jeweiligen Detektors gehalten werden müssen. Ist dies aufgrund einer Unterbrechung nicht mehr der Fall, wechselt der Signalpegel auf der Statusleitung ohne Benutzereinwirkung, wodurch automatisch ein unsicherer Betriebszustand signalisiert wird. Das bedeutet, daß der Eingang der Steuereinheit im sicheren Betriebszustand über den Detektor mit einer Spannungsquelle verbunden ist. Dann wird aufgrund der Unterbrechung der Eingang der Steuereinheit von der Spannungsquelle getrennt und der Signalpegel am Eingang der Steuereinheit nimmt automatisch aufgrund des am Eingang der Steuereinheit vorgesehenen Widerstands einen anderen Signalpegel an.

Die Erfindung wird im folgenden anhand der in der Zeichnung dargestellten Ausführungsformen näher erläutert. Es zeigen:
- Fig. 1:: eine mögliche schaltungstechnische Realisierung der erfindungsgemäßen Anordnung und
- Fig. 2:: eine alternative schaltungstechnische Realisierung der erfindungsgemäßen Anordnung.

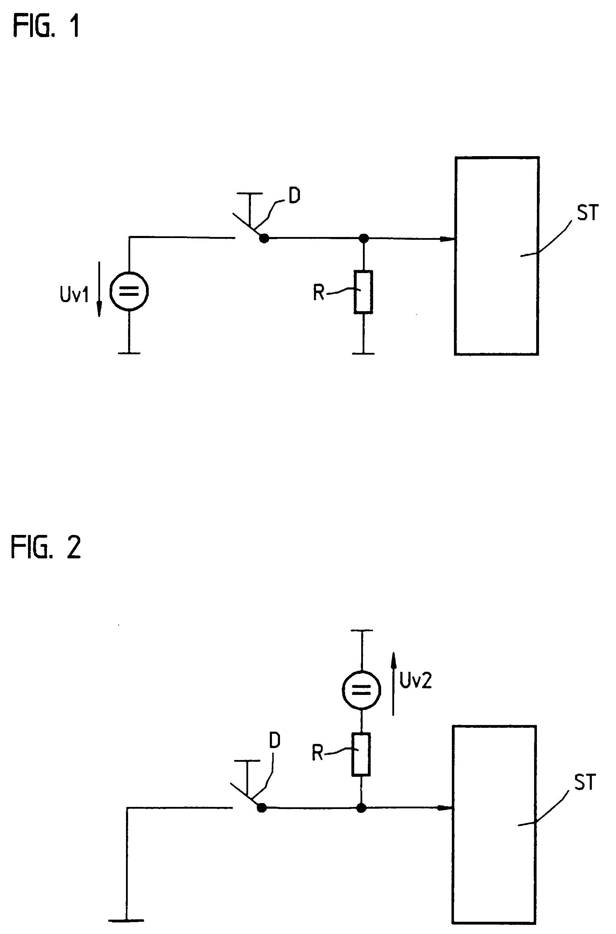

Fig. 1 zeigt eine einfache schaltungstechnische Realisierung zur Durchführung des Verfahrens. Dabei wird davon ausgegangen, daß der als Detektor D verwendete Taster automatisch durch eine geschlossene Schutztür, die den Arbeitsraum einer Werkzeugmaschine begrenzt, geschlossen wird. Bei geöffneter Schutztür unterbricht der Detektor D die Statusleitung zwischen Versorgungsspannung einer ersten Spannungsquelle Uv1 und dem Eingang der Steuereinheit ST. Weiterhin ist ein Widerstand R vorgesehen, der den Eingang der Steuereinheit ST mit Masse, dies entspricht einer zweiten Spannungsquelle Uv2 mit Versorgungsspannung 0V, verbindet und daher als Pull-Down Widerstand wirkt, so daß bei geöffneter Schutztür am Eingang der Steuereinheit ST ein niedriger Signalpegel (logisch 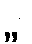 0") eingestellt wird. Der Widerstand R wird so hochohmig gewählt, daß bei geschlossenem Taster ein hoher Signalpegel (logisch 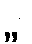 1") am Eingang der Steuereinheit ST anliegt.

Solange der Taster eine geschlossene Schutztür und damit einen sicheren Betriebszustand der Werkzeugmaschine durch einen hohen Signalpegel am Eingang der Steuereinheit ST signalisiert, können alle Funktionen der Werkzeugmaschine durchgeführt werden. Sobald die Schutztür geöffnet wird, öffnet sich auch der Taster und die Statusleitung wird unterbrochen. Die zweite Spannungsquelle Uv2 wird dann über den Widerstand R am Eingang der Steuereinheit ST einen niedrigeren Signalpegel einstellen, da die erste Versorgungsspannung Uv1 nicht mehr mit dem Eingang der Steuereinheit ST verbunden ist. Dadurch wird der Steuereinheit ST signalisiert, daß kein sicherer Betriebszustand mehr vorliegt und die Steuereinheit ST begrenzt daraufhin die Funktionalität der Werkzeugmaschine derart, daß ein sicherer Betrieb dennoch möglich ist. Dies kann dadurch geschehen, daß die Bearbeitungsgeschwindigkeit der Werkzeugmaschine auf eine sicher reduzierte Geschwindigkeit begrenzt wird oder daß ein sicherer Halt der Werkzeugmaschine durchgeführt wird.

Sobald ein Kabelbruch vorliegt, so daß der Eingang der Steuereinheit ST nicht mehr mit der ersten Spannungsquelle Uv1 verbunden ist, kann auch durch den Detektor D kein sicherer oder unsicherer Betriebszustand mehr detektiert werden. Dann empfiehlt es sich, abhängig von dem mittels des jeweiligen Detektors D festgestellten Sicherheitskriterium (Schutztür, Achskonfiguration, Notausschalter, usw.) dieses automatisch als nicht erfüllt anzunehmen.

Für die Schutztür zum Arbeitsraum bedeutet dies, daß diese automatisch als geöffnet angenommen wird. Bei einem Kabelbruch der Statusleitung beispielsweise eines Notausschalters würde dieser automatisch als betätigt angenommen werden. Bei einer Unterbrechung der Statusleitungen der Achskonfiguration wird automatisch der kleinste Arbeitsbereich eingestellt. Dadurch werden automatisch genau die für das aufgrund des Kabelbruchs nicht mehr detektierbare Sicherheitskriterium erforderlichen Schutzmaßnahmen ausgelöst, ohne den Betrieb der Werkzeugmaschine unnötig zu behindern. So kann bei einem Kabelbruch in der Leitung zum Detektor der Schutztür ein Weiterarbeiten der Werkzeugmaschine mit sicher reduzierter Geschwindigkeit noch möglich sein, wohingegen bei einem Kabelbruch in der Leitung zum Notausschalter ein sofortiger sicherer Halt zwingend erforderlich ist.

Bei einem Kabelbruch ist die Verbindung des Eingangs der Steuereinheit ST mit der ersten Versorgungsspannung Uv1 unterbrochen, der Signalpegel am Eingang der Steuereinheit ST wechselt und die Steuereinheit ST interpretiert dies, aufgrund der speziellen Wahl der Signalpegel für sicheren bzw. unsicheren Betriebszustand, ebenfalls als unsicheren Betriebszustand und löst entsprechende Maßnahmen zur Wiederherstellung eines sicheren Betriebszustands aus. Somit entspricht die Reaktion der Steuereinheit ST auf einen Kabelbruch der Statusleitung eines Detektors D genau der Reaktion der Steuereinheit ST auf eine Detektion eines unsicheren Zustands durch den Detektor D, auf dessen Statusleitung eine Unterbrechung aufgetreten ist.

In Fig. 2 ist eine alternative Realisierungsform zu Fig. 1 dargestellt, die aber prinzipiell analog zur oben beschriebenen arbeitet. Der Eingang des Detektors D wird mit Masse verbunden, was einer Verbindung mit einer ersten Spannungsquelle Uv1 für die Versorgungsspannung von Null Volt entspricht. Der Ausgang des Detektors D wird mit einem Eingang der Steuereinheit ST verbunden, in der das Detektorsignal ausgewertet wird. Dabei wird der Steuereinheit ST durch einen hohen Spannungspegel (logisch 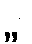 1") ein unsicherer Betriebszustand und durch einen niedrigen Spannungspegel (logisch 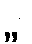 0") ein sicherer Betriebszustand signalisiert. Weiterhin wird über einen Widerstand R, der als Pull-Up Widerstand wirkt, die zweite Versorgungsspannung mit dem Eingang der Steuereinheit ST verbunden.

Im Vergleich zur ersten Realisierungsform werden hier lediglich die am Detektor D und Widerstand R anliegenden Versorgungsspannungen Uv vertauscht, wodurch auch die Signalpegel für sicheren und unsicheren Betriebszustand verglichen mit Fig. 1 vertauscht werden.

Daher ist auch die Wirkungsweise prinzipiell gleich der des ersten Ausführungsbeispiels. Sobald auf der Statusleitung eine Störung durch eine Unterbrechung auftritt, wird der Spannungspegel auf der Statusleitung unabhängig vom Detektorsignal über den Pull-Up Widerstand R mit der zweiten Spannungsquelle verbunden. Dadurch wechselt der Spannungspegel am Eingang der Steuereinheit ST von niedrig (logisch 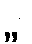 0") auf hoch (logisch 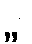 1"), wodurch der Steuereinheit ST ein unsicherer Betriebszustand signalisiert wird. Abhängig von der überwachten Statusleitung wird die Steuereinheit ST unverzüglich Maßnahmen zur Wiederherstellung eines sicheren Betriebszustands auslösen.

Bei beiden Realisierungsformen ist dabei wichtig, daß der Pull-Up oder Pull-Down Widerstand R unmittelbar am Eingang der Steuereinheit ST also unmittelbar am speziellen elektrischen Anschluß des Prozessors vorgesehen ist, da eine Unterbrechung der Statusleitung zwischen Widerstand R und Steuereinheit ST nicht eindeutig festgestellt werden kann. Dadurch wird dieses ungeschützte Stück Statusleitung möglichst kurz gehalten.

Um zusätzliche Redundanz in die Schaltung einzufügen und damit die Signalisierung eines unsicheren Betriebszustands oder eines Kabelbruchs noch zuverlässiger zu gestalten, kann der Widerstand R, der den Signalpegel auf der Statusleitung bei Kabelbruch oder im unsicheren Betriebszustand verändert, als Parallelschaltung aus mehreren Widerständen realisiert werden. Dadurch wird auch dann noch zuverlässig ein unsicherer Betriebszustand signalisiert, wenn ein Widerstand eine Unterbrechung und damit einen unendlich hohen Widerstandswert aufweist. Die parallel geschalteten Widerstände sollten dabei möglichst gleiche Widerstandswerte aufweisen.

Die Schaltungsanordnung kann selbstverständlich für alle Statusleitungen von Detektoren angewandt werden, deren Funktion und korrekte Auswertung aufgrund ihrer Bedeutung für die Betriebssicherheit von Bedeutung sind, beispielsweise Notausschalter, Schlüsselschalter für die Betriebsart, Schalter für die Achskonfiguration, Spannungsüberwachung, Temperaturüberwachung, Reset-Schalter und Drehzahlüberwachung. Für jeden Detektor bzw. jede Statusleitung ist in der Steuereinheit ST mindestens eine Maßnahme gespeichert, die bei einer Unterbrechung automatisch ausgelöst wird.

## Patentansprüche

1. Schaltungsanordnung zur automatischen Einstellung eines sicheren Betriebszustands bei einer Werkzeugmaschine, bei der Detektoren (D), welche sicherheitsrelevante Betriebszustände detektieren, über eine Statusleitung mit einer Steuereinheit (ST) zur Auswertung der Detektorsignale verbunden sind, dadurch gekennzeichnet, daß ein Eingang eines Detektors (D) mit Mitteln (Uv1) zum Einstellen eines Signalpegels verbunden ist, daß ein Eingang der Steuereinheit (ST) für eine Statusleitung mit Mitteln (R) zum Verändern eines Signalpegels verbunden ist, wodurch der Signalpegel der Statusleitung automatisch verändert wird, wenn der Eingang der Steuereinheit (ST) nicht mehr mit Mitteln (Uv1) zum Einstellen eines Signalpegels verbunden ist und daß Mitteln (R) zum Verändern eines Signalpegels in unmittelbarer Nähe des Eingangs der Steuereinheit (ST) angeordnet sind.

2. Schaltungsanordnung nach Anspruch 1, dadurch gekennzeichnet, daß die Mittel (Uv1) zum Einstellen eines Signalpegels eine Spannungsquelle (Uv1) beinhalten.

3. Schaltungsanordnung nach Anspruch 1 oder 2, dadurch gekennzeichnet, daß die Mittel (R) zum Verändern eines Signalpegels eine Spannungsquelle (Uv2) und ein widerstandsbehaftetes Bauteil (R) beinhalten und daß der Eingang der Steuereinheit (ST) über das widerstandsbehaftete Bauteil (R) mit der Spannungsquelle (Uv2) verbunden ist.

4. Schaltungsanordnung nach Anspruch 3, dadurch gekennzeichnet, daß das widerstandsbehaftete Bauteil (R) durch einen oder mehrere parallel geschaltete ohmsche Widerstände (R) realisiert wird.

5. Schaltungsanordnung nach einem der Ansprüche 1 bis 4, dadurch gekennzeichnet, daß die Mittel (R) zum Verändern eines Signalpegels in die Steuereinheit (ST) integriert sind.

6. Schaltungsanordnung nach einem der Ansprüche 1 bis 5, dadurch gekennzeichnet, daß die erste Spannungsquelle (Uv1) einen Signalpegel ausgibt, welcher der Steuereinheit einen ersten logischen Zustand signalisiert und der Eingang der Steuereinheit (ST) über den Pull-Up Widerstand (R) mit einer zweiten Spannungsquelle (Uv2) verbunden ist, die einen Signalpegel ausgibt, welcher der Steuereinheit (ST) einen zweiten logischen Zustand signalisiert oder daß die erste Spannungsquelle (Uv1) einen Signalpegel ausgibt, welcher der Steuereinheit einen zweiten logischen Zustand signalisiert und der Eingang der Steuereinheit (ST) über den Pull-Down Widerstand (R) mit einer zweiten Spannungsquelle (Uv2)verbunden ist, die einen Signalpegel ausgibt, welcher der Steuereinheit (ST) einen ersten logischen Zustand signalisiert.
